# EUROPÄISCHE PATENTSCHRIFT

(11) **EP 4 144 821 B1**
(45) Veröffentlichungstag und Bekanntmachung des Hinweises auf die Patenterteilung: **18.10.2023**
(21) Anmeldenummer: 22189994.1
(22) Anmeldetag: 11.08.2022
(51) Int. Cl.: H02G 3/08, C09K 21/06, H02G 3/04, C08L 1/02

(54) **BRANDSCHUTZVORRICHTUNG UND VERFAHREN ZU DESSEN HERSTELLUNG**
FIRE SAFETY DEVICE AND METHOD OF MAKING THE SAME
DISPOSITIF DE PROTECTION CONTRE L'INCENDIE ET?SON PROCÉDÉ DE FABRICATION

(30) Priorität: 11.08.2021 DE 102021120921
(43) Veröffentlichungstag der Anmeldung: 08.03.2023
(73) Patentinhaber: Celsion Brandschutzsysteme GmbH, 01219 Dresden (DE)
(72) Erfinder: SCHUBERT, Boris, 01219 Dresden (DE)
(74) Vertreter: Lippert Stachow Patentanwälte Rechtsanwälte Partnerschaft mbB

(56) Entgegenhaltungen:
- EP-A1- 2 993 746
- WO-A1-2021/136883

## Beschreibung

Die Erfindung betrifft allgemein eine Brandschutzvorrichtung, welche einen Raum ein- oder mehrseitig begrenzt und dazu eine oder mehrere den Raum begrenzende Wandungen oder einem den Raum begrenzenden Hohlkörper mit einer Brandschutzklasse mit Feuerwiderstand von mindestens El; EW 15 umfasst. Die Erfindung betrifft insbesondere ein Brandschutzgehäuse mit einer Wandung oder einem Hohlkörper der Feuerwiderstandsklasse EI; EW 15 oder höher. Die Erfindung betrifft auch ein Verfahren zur Herstellung einer solchen Brandschutzvorrichtung.

Als Brandschutzgehäuse wird ein Gehäusesystem aus brennbaren oder nicht brennbaren Materialien bezeichnet, welche dem Funktionserhalt oder der Brandlastdämmung von elektrischen Einrichtungen dienen. Derartige Brandschutzgehäuse sind als mit einer Wand verbundene Wandgehäuse, beispielsweise aus der EP 2 993 746 A1, bekannt mit zumindest einer Wandung, in diesem Fall mit einer Tür, die optional in eine Frontwandung eingelassen ist oder allein die frontseitige Begrenzung des Raumes bildet, oder als Standgehäuse freistehend ausgeführt oder vor eine Wand oder Nische gesetzt sind. Bei einem Standgehäuse wird das Gehäuse durch ein Volumen allseitig umschließende Wandungen gebildet.

Nachfolgend soll der Begriff "Brandschutzvorrichtung" allgemein Vorrichtungen bezeichnen, welche dem Brandschutz dienen und zu diesem Zweck ein Brandschutzverhalten aufweisen, welches durch die gängigen Brandschutznormen festgelegt ist. Darunter zählen sowohl komplexe Vorrichtungen als auch deren Komponenten. Sofern es für komplexe, aus mehreren Komponenten bestehende Brandschutzvorrichtungen gängige oder festgelegte Begriffe gibt, werden diese hier verwendet, wie z. B. das Brandschutzgehäuse, Brandschutzverteiler, Sicherheitsgehäuse, Sicherheitsschrank, Gefahrstoffschrank oder vergleichbare Vorrichtungen. Die nachfolgenden Darlegungen zur Ausführung der Wandung oder des Hohlkörpers eines Brandschutzgehäuses sind analog auch auf diese Brandschutzvorrichtungen übertragbar.

Derartige Brandschutzvorrichtungen und Brandschutzgehäuse weisen verschiedene ergänzende funktionale Komponenten auf, welche in den Brandschutznachweis der Vorrichtung bzw. des Brandschutzgehäuses einbezogen sind und der Funktion der betreffenden elektrischen Einrichtung bzw. deren Schutz oder Abschottung im Brandfall der Einrichtung dienen. Dazu gehören beispielsweise Befestigungsmittel und/oder Verbindungen der Wandelemente, Scharniere, Schließsysteme, Kabelschotts, Rauchdichtigkeitssystem, Be- und Entlüftungen, Messsysteme zur Rauch- und Brandfrüherkennung, Klimasysteme und andere.

Gegenwärtig werden für den mehrschaligen Wandaufbau der Brandschutzvorrichtungen ein-, meist jedoch mehrschalige Gipsplatten mit Mineralfaser- oder anderen Wärmedämmplatten kombiniert, um die Anforderungen hinsichtlich Brandlast, Rauchdichtheit und Funktionserhalt zur erfüllen. Der Wandaufbau weist zumindest drei, häufig jedoch mehr wärmedämmende und/oder stabile Schalen auf, die zunehmend komplexere Wandsysteme bilden. Diese können mit Kühlvorrichtungen und/oder speziellen Beschichtungen ausgestattet sein. Insbesondere die Anforderungen der Rauchdichtheit erfordern an Stellen, an welchen zwei Wände miteinander zu verbinden sind, besondere Maßnahmen, wie ein mehrstufiger Aufbau mit zueinander versetzten Schichten, der insbesondere im Bereich von Wandöffnungen, wie Türen, Durchführungen beispielsweise für Kabel, Lüftungssystemen oder anderes, itumeszierende, d. h. unter Hitzeeinwirkung aufschäumende, Beschichtungen u. ä. auf, um Spalten rauchdicht zu verschließen. Im Ergebnis folgt ein zunehmender Bedarf an Gips- und Wärmedämmplatten und ein sehr komplexer, aufwendiger Wandaufbau.

Auch wenn Gips recycelbar ist, ist dieser Rohstoff endlich, insbesondere aufgrund der Verbindung der Gipsbauteile als Verbund mit anderen Materialien beispielsweise als beschichtete und unbeschichtete Platten, welche aufwändig oder schwierig voneinander zu trennen sind.

Es besteht daher der Bedarf nach einem nachhaltigen Ersatz für Mineralfaser-und Gipsplatten, welche für Brandschutzsysteme anwendbar und mit den notwendigen ergänzenden funktionalen Komponenten verbindbar sind, so dass das betreffende Brandschutzbauteil als solches die brandschutztechnischen Anforderungen und Tests erfüllt.

Sowohl hinsichtlich der Materialauswahl als auch des Herstellungsprozesses ist die Nachhaltigkeit des Produkts ein weiterer Aspekt der Erfindung.

Das Konzept der Erfindung kann dahingehend beschrieben werden, dass für die eine oder mehrere Wandungen oder den Hohlkörper, nachfolgend zusammenfassend auch als Brandschutzbauteil bezeichnet, einer Brandschutzvorrichtung ein Verbundmaterial verwendet wird, welches ein Cellulosematerial, z.B. organisches Cellulosematerial, als das volumenbildende Material des Verbunds aufweist. Das Cellulosematerial ist von dem filamentösen Organismus eine Pilzmyzeliums durchsetzt, welcher dem Cellulosematerial die gewünschte Form und Festigkeit verleiht. Bei der Auswahl des Cellulosewerkstoffs können vorwiegend regional verfügbare Ausgangsstoffe verwendet werden.

Es wurde festgestellt, dass für das Cellulosematerial in Verbindung mit dem filamentösen Organismus darüber hinaus auch Brandschutzeigenschaften realisierbar sind. Derartige Brandschutzbauteile können feuerhemmend EI; EW 15 bis feuerbeständig F90 und sogar F120 ausgebildet werden. Die Anforderungen an den Feuerwiderstand einer Brandschutzvorrichtung sind in der Europäischen Norm EN 13501-2 Teil 2 festgelegt. Die Klasse E beschreibt eine raumabschließende Funktion der Brandschutzvorrichtung und die Bezeichnung I bzw. W betrifft die Isolation bzw., Wärmedämmung, die ausreichend ist, im für den betreffenden Klassifizierungszeitraum, in den angeführten Beispielen 30, 90 oder 120 Minuten, eine ausreichend starke Hitzebarriere zum Schutz von Menschen in der Nähe der Brandschutzvorrichtung bei einseitiger Brandbeanspruchung zu gewährleisten.

Als Cellulosematerial kommen insbesondere Cellulosefaserstoffe von verholzenden und nichtverholzenden Pflanzen zur Anwendung. Alternativ oder in Kombination miteinander können auch Cellulose-Regenerate oder Cellulosederivate verwendet werden. Als natürliche Cellulose, dem Hauptbestandteil pflanzlicher Zellwände, kommen beispielsweise Holzfasern, Hanf, Flachs, Getreidestroh, Maisstroh, Bambus, Mehl oder andere zu Anwendung. Auch Abfälle aus Biogasanlagen sind verwendbar. Als Celluloseregenerate werden Fasern bezeichnet, welche wie auch die oben genannten aus natürlich vorkommenden, nachwachsenden Rohstoffen in chemischen Prozessen hergestellt werden und deshalb nicht zu den Naturfasern zu zählen sind. Cellulosederivate hingegen sind chemische Derivate von Cellulose.

Über die Auswahl einer Faserart, die Faserdicke sowie Faserlänge und/oder einer Mischung aus verschiedenen Cellulosefasern und/oder Fasergrößen können wichtige Eigenschaften wie Dichte, Struktur, Festigkeit, Stabilität, Aussehen und weitere Eigenschaften, insbesondere der Feuerwiderstand, variiert werden.

Der filamentöse Organismus eines Pilzmyzeliums ist durch ein fadenförmiges Wachstum in ein Substrat, vorliegend das Substrat aus Cellulose, gekennzeichnet. Das Substrat zersetzt sich infolge des Wachstums teilweise. Der filamentöse Organismus ist dadurch charakterisiert, dass er vielzellige End-to-End-Anordnungen bildet. Die während des Wachstums entstehende Verflechtung der Filamente bildet eine mattenartige Struktur, welche die Cellulose infolge des Wachstums teilweise zersetzt und einschließt. Das Wachstum kann durch die Umgebungsbedingungen unterstützt und reguliert werden sowie gestoppt werden.

Ein Myzelium, das Wurzelwerk von Pilzen, ist geeignet, innerhalb von Tagen in einem solchen Umfang in das Cellulosematerial zu wachsen, dass das Brandschutzbauteil für eine Brandschutzvorrichtung herstellbar ist. Für die gewünschten Brandschutzeigenschaften haben sich beispielsweise Pilze aus der Gattung der Trameten als vorteilhaft erwiesen. Derartige Pilze gehören zu den Lignin (einem Holzbestandteil) abbauenden Pilzen. Beispielsweise hat sich der echte Zunderschwamm für die Herstellung von Brandschutzvorrichtungen als günstig erwiesen. Aufgrund der vielfältigen verwendbaren Cellulosefasern können verschiedene Pilzmyzelien zur Anwendung kommen, wobei in Abhängigkeit von den gewünschten Brandschutzeigenschaften die verwendbare Kombination von Cellulosefasern und Pilzen durch Versuche festzustellen ist.

Das auf diese Art gewonnene Material gestattet es insbesondere, dass die Wandungen des Brandschutzbauteils einlagig ausgebildet werden können, ohne Verlust an Brandschutzeigenschaften. Der aufwändige mehrlagige Aufbau mit drei oder mehr Schichten, die miteinander zu verbinden waren, kann vermieden werden.

Weitere für das Herstellungsverfahren vorteilhafte technologisch bedingte Zusatzstoffe zu den beiden Hauptbestandteilen sind möglich. So führen Zusätze von geschreddertem Abfallgips zu einer verbesserten Verarbeitung der Ausgangsmischung und damit verbunden zu einer höheren Feuerbeständigkeit und Stabilität. Der Abfallgips kann aus Rückbauten von Gipswänden oder der Herstellung von Gipsplatten stammen und kann einschließlich vorhandener Oberflächenschichten, beispielsweise Papier, verwendet werden. Derartige Zusätze weisen meist einen einstelligen Volumenanteil, bezogen auf das Gesamtvolumen, auf, wobei in Abhängigkeit von dem verwendeten Cellulosematerial auch höhere Volumentanteile von Vorteil sein können, beispielsweise bis zu einem Anteil von 12% oder 13% oder 14% oder 15%. Auch hier sind Versuche mit den verwendeten Cellulosmaterialien geeignet, um den optimalen Anteil für den Einzelfall zu ermitteln.

Auch eine farbliche Gestaltung des Materialgemisches und damit der daraus hergestellten Brandschutzvorrichtung kann erfolgen, beispielsweise um mit der Farbe die Brandschutz- und/oder Materialeigenschaften zu dokumentieren. Eine farbliche Gestaltung ist durch die Wahl der Art der Cellulosefasern und/oder durch farbgebende Zusatzstoffe möglich.

Ein Brandschutzbauteil kann aus einem auf diese Weise gewachsenen Block des Verbundmaterials geschnitten werden. Oder es wird eine Form bereitgestellt, deren Formhöhlung eine Geometrie aufweist, welche jener des gewünschten Brandschutzbauteils, optional auch der gesamten Wandung einer Brandschutzvorrichtung oder eines mehrere Bauteile umfassenden, zusammenhängenden Bestandteils davon entspricht. Bei der Verwendung einer Form kann die Dichte und auch das Brandschutzverhalten des Brandschutzbauteils aktiv beeinflusst werden, da mit fortgesetztem Wachstum des Pilzmyzeliums die Dichte des Verbundmaterials zunimmt. Durch ein Nach verpressen können Eigenschaften für beide Varianten der Herstellung weitergehend beeinflusst werden.

Ein weiterer Vorteil des Wachstums des filamentösen Organismus in das Cellulosematerial besteht in der Möglichkeit, notwendige funktionale Komponenten der Brandschutzvorrichtung unmittelbar oder mit geeigneten Hilfsmitteln in der Form final zu positionieren und auf diese Weise einwachsen zu lassen. Solche funktionalen Komponenten sind beispielsweise Scharniere, Verschlüsse, Griffe, Verbindungselemente für zusammengehörige Brandschutzbauteile derselben oder anderer Materialien. Die benannten funktionalen Komponenten können eine strukturierte Außenkontur aufweisen, welche die Haltbarkeit in den schwamm- oder gewebeartigen Strukturen verbessern.

Derartig konturierte Komponenten sind beispielsweise von Schraubverbindungen bekannt, bei denen sogenannte Schraubdübel mit breitem Gewinde großer Steigung in die Struktur eingebracht werden. Auch Durchführungen, beispielsweise mittels Rohren, Muffen, Schläuchen oder anderen Ausführungen, für Kabel, Belüftungen, Sensorik oder anderes sind in das Wachstum integrierbar, so dass die final erzeugte Struktur des Brandschutzbauteils nachträglich nicht oder nur minimal durch Einarbeiten derartiger notwendiger Komponenten beeinflusst werden muss.

Zur Herstellung der Brandschutzvorrichtung wird das Cellulosematerial mit dem filamentösen Organismus oder mit einer Vorstufe davon, aus welcher sich ein solcher Organismus bilden lässt, gleichmäßig vermischt. Bei einem Pilzmyzelium sind die Sporen als Vorstufe verwendbar und mit den Cellulosefasern zu mischen. Beispielsweise werden Holzspäne einer Akazie mit Sporen der oben genannten Pilssorten vermischt. Das Mischungsverhältnis kann in Abhängigkeit vom Cellulosematerial und der Pilzsorte durch Versuche ermittelt werden. Über den Anteil der Sporen ist insbesondere die Dauer des Myzelwachstums bis zur gewünschten Dichte des Bauteils optimierbar

Aus dieser Mischung wird unter Zugabe von Flüssigkeit, beispielsweise Wasser eine pastöse Masse hergestellt, welche eine solche Konsistenz aufweist, dass sie entweder zum Block verarbeitet oder in eine Form gefüllt werden kann.

Es hat sich herausgestellt, dass der pH-Wert der pastösen Masse einen Einfluss auf das Pilzwachstum und daraus folgend die Funktionalität des Bauteils hat. Ein saurer pH-Wert, d.h. kleiner 7 hat sich als vorteilhaft herausgestellt. Da die Sporenzugabe die Masse saurer werden lässt und Werte im Bereich von 4 bis 6, bevorzugt von 5 bis 6 als Ausgangswert für die nachfolgende Behandlung vorteilhaft sind, Ist die Sporenzugabe und gegeben falls die Zugabe von Zusatzstoffen entsprechen zu wählen.

Diese Mischung wird in eine Form gefüllt und dort den für das Wachstum des filamentösen Organismus erforderlichen Umgebungsbedingungen, insbesondere hinsichtlich Temperatur, Feuchtigkeit und Lichtverhältnissen, ausgesetzt. Zu diesem Zweck ist die Form zumindest für die benötigten Wellenlängen transparent ausgebildet. Das sind insbesondere Wellenlängen im Infrarotbereich und dem Bereich des sichtbaren Lichts. Die Umgebungsbedingungen während des Wachstums des filamentösen Organismus sind so auszuwählen und gegebenenfalls durch Versuche zu ermitteln, dass die Zusammensetzung aus Cellulosematerial und Wurzelmyzelium in einem für die gewünschten Brandschutzeigenschaften erforderlichen Verhältnis, insbesondere Volumenverhältnis, bleiben. Für die genannten Pilze der Gattung der Trameten und weitere verwendbare Pilzarten kann die Temperatur auf Werte im Bereich von 20°C bis kleiner 50°C, bevorzugt 25°C bis 45°C, weiter bevorzugt 30°C bis 40°C, eingestellt werden. Auch für die Ermittlung der günstigen Temperatur sind vorherige Versuche nutzbar. Liegt aus solchen Versuchen ausreichend Datenmaterial zur Verfügung kann die Mischung und der Wachstumsprozess auch mittels Simulation ermittelt werden.

Für die zuvor genannte Mischung aus Holzspänen und Pilzsporen haben sich, je nach Wandungsdicke, Feuchtigkeit im pastösen Material und dem pH-Wert Temperaturen im Bereich von ca. 20°C als optimal herausgestellt.

Diese Temperaturen ist beispielsweise unter Einwirkung von Tageslicht hoher Lichtintensität, insbesondere von Sonneneinstrahlung erzielbar, welche eine Beleuchtungsstärke im Bereich von ca. 20000 Ix bis ca. 90000 Ix aufweist, Bei der Einstellung der Temperatur ist zu berücksichtigen, dass für ein möglichst gleichmäßiges Durchwachsen der Ausgangsmasse diese Temperatur im Kern der Masse erzielbar sein sollte, so dass die Außentemperaturen durchaus höher liegen können, Die Feuchtigkeit der Ausgangsmasse hat einen deutlichen Einfluss auf die Kerntemperatur. Temperaturen über 50°C stoppen jedoch das Wachstum und können je nach Art des Myzeliums dieses abtöten. Anstelle des natürlichen Lichts können auch andere Wärmequellen verwendet werden, mit welchen die genannten Temperaturbereiche erzielbar sind. Mittels des natürlichen Lichts gestaltet sich die Energiebilanz des Verfahrens jedoch wesentlich günstiger.

Werden, wie oben beschrieben, Komponenten der betreffenden Brandschutzvorrichtung an den gewünschten Positionen in der Form angeordnet, so dass die später innerhalb der Vorrichtung liegenden Abschnitte der Komponenten in die Form hineinragen, werden die Komponenten infolge des Myzelwachstums vom Materialverbund zunehmend fester umschlossen. Beispielsweise bei einer Brandschutztür, welche eine Ausnehmung innerhalb einer Trennwand eines Gebäudes verschließt, können das Scharniere, Befestigungsmittel der Brandschutztür an der Wand, Griffe der Tür, Durchlässe durch die Tür für Kabel, Lüftung o. ä. und gegebenenfalls weitere Komponenten sein.

Während seiner Wachstumsphase zersetzt und durchsetzt das Myzelium das Cellulosematerial gleichmäßig und verfestigt es dabei. Ist die gewünschte Zusammensetzung des Verbundmaterials erreicht, kann der Wachstumsprozess des Myzeliums durch die Erhöhung der Temperatur gestoppt werden. Für die beispielhaft genannte Verwendung von Akazienholzfasern und dem echten Zunderschwamm hat sich eine Erhöhung auf 50°C als günstig erwiesen. Höhere Werte sind möglich und effizienter, wobei sich Werte im Bereich von 70°C bis kleiner 100°C, bevorzugt im Bereich von im Bereich von 75°C bis kleiner 100°C, weiter bevorzugt im Bereich von 80°C bis kleiner 100°C als vorteilhaft erwiesen haben, um auch im Kernbereich des Bauteils den Wachstumsprozess sicher zu stoppen, Bei den genannten Temperatur bleibt das stabile Gerüst des Myzeliums bestehen, ohne seine Struktur und Stabilität zu verlieren. Nur der Fruchtkörper, insbesondere die für das Wachstum sorgenden Sporen des Pilzes werden zerstört. Im Ergebnis ist ein Verbundmaterial aus Holzfasern mit einer karbonhaltigen Stützstruktur entstanden.

Das Wandungsgerüst des Brandschutzbauteils mit den integrierten funktionalen Komponenten kann nunmehr aus der Form entnommen werden und mit erforderlichen weiteren funktionalen Bestandteilen zu einer funktionsgerechten Brandschutzvorrichtung komplettiert werden. Letztere betreffen je nach Art der Brandschutzvorrichtung beispielsweise ein Schließsystem, Verbindungsmittel, wie nachfolgend beschrieben, Scharniere, Wandeinbauten, wie Lüftungssysteme, Kabeldurchführungen o.ä., Sensorik und anderes.

Gegebenenfalls kann, in Abhängigkeit von den gewählten Materialien und der gewünschten Dichte, eine nachträgliche Verpressung des Verbundmaterials erfolgen. Die Verpressung kann in der Form erfolgen, in welcher das Verbundmaterial hergestellt wurde, oder in einer separaten Presse, nach Entnahme des Brandschutzbauteils aus der Form.

Das erfindungsgemäße Brandschutzbauteil und das zugehörige Herstellungsverfahren sind insbesondere durch den energieschonenden Herstellungsprozess sowie die verwendeten Ausgangsstoffe nachhaltig. Darüber hinaus ist das Brandschutzbauteil nach seiner Verwendung kompostierbar, so dass dessen nichtkompostierbaren Komponenten aus Metall oder Kunststoff einfach zu separieren sind, beispielsweise durch Sieben oder mittels Magneten.

Da neben den verwendeten Zellulosefasern, bei denen aus Gründen der Nachhaltigkeit bevorzugt auf lokal verfügbare Rest-, Abfall- und/oder Recyclingmaterialien zurückgegriffen werden kann, der Anteil der Sporen des Myzeliums und die Feuchtigkeit der Ausgangsmasse sowohl auf die wesentlichen Eigenschaften des fertigen Materials der Brandschutzvorrichtung als auch auf die Dauer und Effizienz des Verfahrens wesentlichen Einfluss haben, ist deren Einstellung im Wesentlichen eine Frage der Optimierung des Verfahrens.

Die Erfindung soll anhand eines Ausführungsbeispieles näher erläutert werden. Die zugehörigen Zeichnungen zeigen in
Fig. 1 eine Ausführungsform eines freistehenden Brandschutzgehäuses in perspektivischer Darstellung,
Fig. 2 eine Ausführungsform eines wandständigen Brandschutzgehäuses in der Darstellung eines Horizontalschnitts und
Fig. 3 das Detail A einer Ecke des Brandschutzgehäuses gemäß Fig. 2.

Die Figuren zeigen die Erfindung nur schematisch und in einem solchen Umfang, wie es für das Verständnis der Erfindung erforderlich ist. Sie erheben keinen Anspruch auf Vollständigkeit oder Maßstäblichkeit. Der Fachmann würde die in obiger Beschreibung und nachfolgend dargestellten Merkmale in weiteren Ausführungsformen miteinander kombinieren, soweit es ihm sinnvoll erscheint.

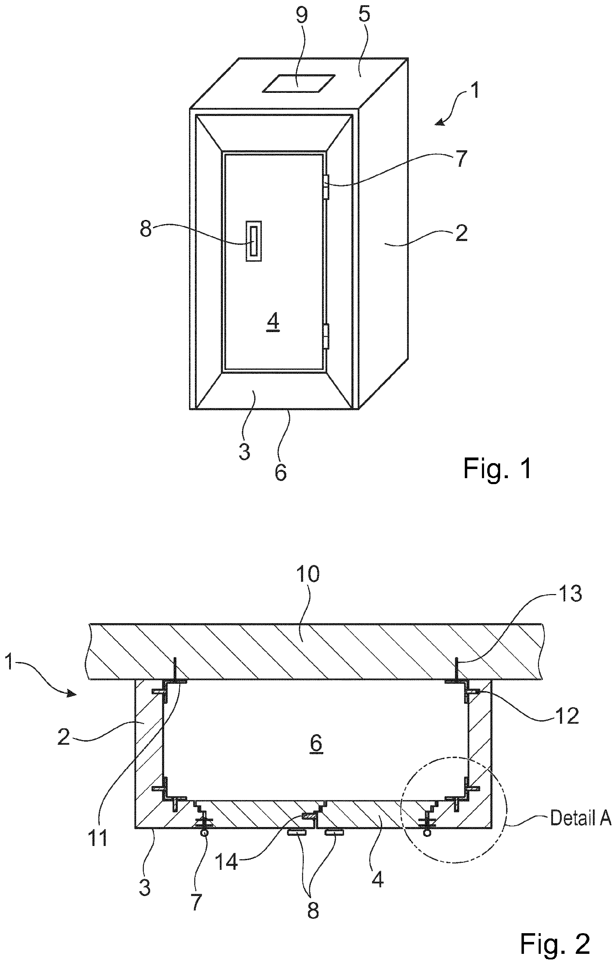

Das Brandschutzgehäuse gemäß Fig. 1 umfasst vier Umfassungswände, und zwar zwei Seitenwände 2, eine Frontwand 3, in welche eine einflügelige Tür 4 eingesetzt ist, und eine Decke 5 sowie einen Boden 6. Die Tür 4 ist mittels Scharnieren 7 schwenkbar gestaltet und mittels eines Handgriffs 8 verschließbar. In der Decke, optional oder ergänzend auch in anderen Positionen des Brandschutzgehäuses 1, ist ein Wanddurchlass 9 angeordnet. Dieser ist beispielhaft jedoch nicht beschränkend durch ein Kanalgehäuse gebildet, in welches die benötigten Einbauten integriert sind oder nachträglich integriert werden können. Derartige Wanddurchgänge sich beispielsweise für Kabeldurchführungen, Lüftungssysteme oder anderes erforderlich.

Derartige Brandschutzgehäuse 1 umschließen regelmäßig einen Elektroverteiler (nicht dargestellt), dessen Funktionserhalt im Brandfall über eine definierte Zeitspanne gesichert werden soll.

Alle Umfassungswände des Brandschutzgehäuses 1 sowie die Tür 4 sind aus dem erfindungsgemäßen, oben näher beschriebenen Verbundbaustoff hergestellt, Dieser umfasst eine Mischung aus verschiedenen natürlichen Cellulosefasern mit weiteren Zusätzen, wie beispielsweise Gipsabfälle, deren Gesamtanteil im einstelligen Prozentbereich liegt, und einem durch Hitze gemäß obiger Verfahrensbeschreibung abgetöteten Pilzmyzelium eines Pilzes aus der Gattung der Trameten.

Alle sechs Seiten des Brandschutzgehäuses 1 sind im Ausführungsbeispiel einteilig, d.h. ohne die im Stand der Technik notwendige Stufenverbindung zwischen den separaten Wänden, ausgebildet. Lediglich die Tür ist ein separates Bauteil. Sofern es erforderlich wäre, eine oder mehrere der genannten Wände als separate Wände auszuführen und mit den übrigen erfindungsgemäß gefertigten oder anderen vorhandenen Wänden zu verbinden, ist das erfindungsgemäßen Verbundmaterial auch geeignet, die aus dem Stand der Technik bekannten hitze-und rauchdichten Verbindungen von Wänden oder Wandteilen anzuwenden.

Fig. 2 zeigt eine wandständige Ausführungsform eines Brandschutzgehäuses 1. Dieses ist an einer bestehenden feuerbeständigen Wand 10 fest montiert. Das Brandschutzgehäuse 1 umfasst eine Frontwand 3, in welcher eine zweiflügelige Tür 4 mittig angeordnet ist. Deren Türflügel sind mittels Scharnieren 7 schwenkbar und Handgriffen verschließbar.

Das Brandschutzgehäuse 1 umfasst weiter zwei Seitenwände 2 und eine Decke (nicht dargestellt) sowie einen Boden 6. Auch die Bauteile dieses Brandschutzgehäuses 1 bestehen aus einem Verbundbaustoff, wie zu Fig. 1 beschrieben und sind - optional alle -, mit Ausnahme der beiden Türen 4, einstückig hergestellt.

Die Rückwand des Brandschutzgehäuses 1 wird durch die bestehende Wand 10 gebildet. Zu diesem Zweck ist des Brandschutzgehäuse 1 mittels Verbindungsmitteln 11, beispielsweise mittels Winkelverbinder, mit der Wand 10 sowie den Seitenwänden 2, dem Boden 6 und der Decke (nicht dargestellt) fachmännisch hitze- und rauchdicht mittels Schrauben 13 oder ähnliches verbunden.

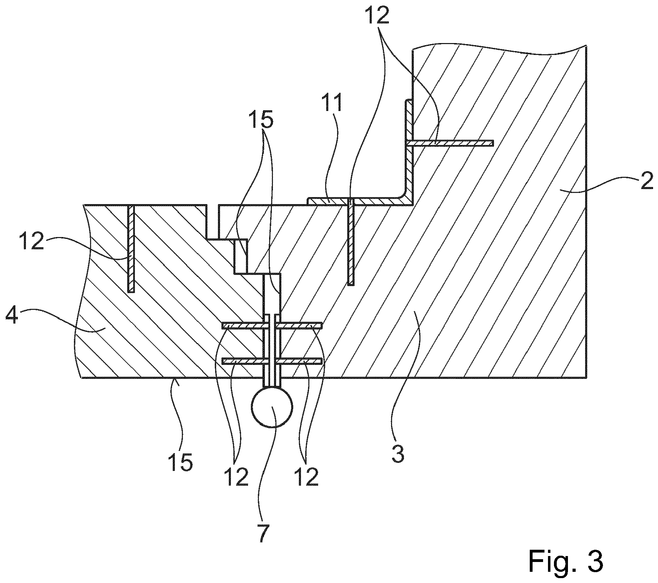

Jene Schrauben 13, welche in die Bauteile des Brandschutzgehäuses 1 geschraubt sind, werden von Halteelementen 12 aufgenommen, wie beispielsweise Dübel mit einer spiralförmigen Außenkontor mit breiten Stegen, wie sie beispielsweise von Gipskartondübeln bekannt sind. Andere Varianten der Halteelemente sind möglich. Die Halteelemente 12 wurden, wie oben beschrieben, bereits bei der Herstellung des Brandschutzgehäuses 1 oder des Bauteils in das Verbundmaterial eingearbeitet. In der Darstellung in Fig. 2 und Fig. 3 sind derartig außenkonturierte Halteelemente 12 im Verbundmaterial schematisch durch ein Rechteck dargestellt. Schrauben 13, die unter Verwendung der üblichen Dübel in die Wand 10 eingebracht werden, sind zur Unterscheidung durch Linien dargestellt.

Der seitliche Anschluss der beiden Türen 4 an die Frontwand 3 erfolgt fachmännisch hitze- und rauchdicht mit aus dem Stand der Technik bekannten und in Fig. 3 beispielhaft aber nicht beschränkend dargestellten Stufenprofilen. Auch die mittige Verbindung der beiden Türen 4 ist in Analogie dazu mittels bekannter Stufenprofilen hitze- und rauchdicht ausgeführt.

Auch die in die Türen einzubringenden Bestandteile des Türschlosses 14, dessen Handgriffe 8 oder zumindest deren Verbindungsmittel (nicht dargestellt) sind bereits bei der Herstellung der Bauteile des Brandschutzgehäuses 1 eingearbeitet. Welche Bestandteile und/oder Verbindungsmittel das sind, hängt von dem verwendeten Verschluss ab und kann verschiedenste Ausführungen haben.

Fig. 3 zeigt die Ausbildung der schwenkbaren Verbindung einer Tür 4 mit der Frontwand 3 und den sich daran anschließenden Eckbereich. Die stufenförmig ausgebildete Verbindung weist beispielhaft jedoch nicht beschränkend eine dreistufige Verbindung auf. An deren senkrecht zur Außenseite 15 der Tür liegenden Flächen der Stufen sind fachmännisch bekannte Dichtungsmittel 16 angeordnet, beispielsweise intumeszierende Beschichtungen oder Lippendichtungen oder ähnliches. Andere Ausführungen und Anordnungen der Dichtungsmittel 16 sind möglich.

Optional können im Inneren des Brandschutzgehäuses 1, beispielsweise in den Innenecken Verbindungsmittel 11 mittels der Halteelemente 12 wie oben zu Fig. 2 beschrieben, eingefügt werden. Diese können der Aussteifung des Brandschutzgehäuses 1 oder der Montage von Inneneinbauten (nicht dargestellt) des Brandschutzgehäuses 1 dienen.

Die Scharniere 7 sind ebenfalls mit Schrauben (nicht dargestellt) und den oben beschriebenen Halteelementen 12 im Verbundmaterial befestigt. Die Halteelemente 12 sind im Ausführungsbeispiel ebenfalls mit dem Bauteil vorgefertigt.

Die Wandungen der Brandschutzgehäuse nach den Fig. 1 bis Fig. 3 sind mit einer Dicke im Bereich von 80 bis 100 mm mit dem oben beschriebenen Verfahren hergestellt, wobei der pH-Wert der pastösen Masse einen Wert von 6 aufweist. Das Pilzmyzelium wurde unter Ausnutzung von Tageslicht auf im Kern 20°C zur Anregung des Wachstums des Myzeliums erwärmt. Das Wachstum wurde mittels Kerntemperaturen im Bereich von 80°C gestoppt und das Myzelium verhärtet. Die Gehäuse und Türen wurden aus der Form gelöst und mittels der vorgefertigten Komponenten zur Montage der Türen an der einstückigen Gehäusewandung sowie gemäß Fig. 2 an der bestehenden Wand montiert.

### Bezugszeichenliste

- 1: Brandschutzgehäuse
- 2: Seitenwand
- 3: Frontwand
- 4: Tür
- 5: Decke
- 6: Boden
- 7: Scharnier
- 8: Handgriff
- 9: Wanddurchführung
- 10: Wand
- 11: Verbindungsmittel
- 12: Halteelemente
- 13: Schrauben
- 14: Türschloss
- 15: Außenseite
- 16: Dichtungsmittel

## Patentansprüche

1. Brandschutzvorrichtung, welche einen Raum ein- oder mehrseitig begrenzt mit zumindest einer den Raum begrenzenden Wandung oder einem den Raum begrenzenden Hohlkörper, nachfolgend zusammenfassend als Brandschutzbauteil bezeichnet, welche zumindest einen Feuerwiderstand der Klasse El; EW 15 aufweisen, **dadurch gekennzeichnet, dass** das Brandschutzbauteil aus einem Verbundmaterial besteht, welches Cellulosefasern als volumenbildenden Bestandteil, nachfolgend auch als Substrat bezeichnet, aufweist und dass das Volumen der Cellulosefasern von einem nicht mehr lebenden filamentösen Organismus eines Pilzmyzeliums durchsetzt ist.

2. Brandschutzvorrichtung nach Anspruch 1, **dadurch gekennzeichnet, dass** als Cellulosefasern eine Art aus folgender Liste oder einer Mischung mehrerer Arten der Liste enthalten ist: Holzfasern, Hanf, Flachs, Getreidestroh, Maisstroh, Bambus, Mehl, Abfälle aus der Biovergasung, Cellulose-Regenerate, Cellulosederivate.

3. Brandschutzvorrichtung nach einem der vorstehenden Ansprüche, **dadurch gekennzeichnet, dass** das Pilzmyzelium zumindest eine Art eines Lignin abbauenden Pilzes ist.

4. Brandschutzvorrichtung nach einem der vorstehenden Ansprüche, **dadurch gekennzeichnet, dass** das Material des Brandschutzbauteils geschredderten oder gemahlenen Gips, bevorzugt von Abfallgips, als Zusatz umfasst.

5. Brandschutzvorrichtung nach einem der vorstehenden Ansprüche, **dadurch gekennzeichnet, dass** die Wandung oder die Wandungen des Brandschutzbauteils einlagig und/oder das Brandschutzbauteil integral ausgebildet sind.

6. Brandschutzvorrichtung nach einem der vorstehenden Ansprüche, **dadurch gekennzeichnet, dass** die Brandschutzvorrichtung ein Brandschutzgehäuse ist.

7. Verfahren zur Herstellung einer Brandschutzvorrichtung nach einem der vorstehenden Ansprüche, folgende Verfahrensschritte in der angegebenen Reihenfolge umfassend:
- Bereitstellung einer Mischung aus Cellulosefasern und Sporen eines Pilzes,
- Herstellung eines pastösen Ausgangsmaterials aus der Cellulosefaser-Sporen-Mischung mittels Flüssigkeitszufuhr, derart dass das Ausgangsmaterial einen pH-Wert im Bereich von 4 bis 6 aufweist,
- Einfüllen des pastösen Ausgangsmaterials in eine Form,
- Erwärmung des Ausgangsmaterials auf eine Temperatur im Bereich von 20°C bis kleiner 50°C zur Anregung des Wachstums des Pilzmyzeliums,
- Erwärmung des infolge des Wachstums des Pilzmyzeliums entstandenen Verbundmaterials auf eine Temperatur im Bereich von 50°C bis kleiner 100°C zur Beendigung des Wachstumsprozesses des Pilzmyzeliums, und
- Entnahme des verfestigten Brandschutzbauteils aus der Form.

8. Verfahren nach Anspruch 7, wobei die Temperaturen bei der ersten und/oder der zweiten Erwärmung im Kernbereich der Wandung erzeugt werden.

9. Verfahren nach Anspruch 7 oder 8, wobei in einem weiteren Verfahrensschritt eine Verpressung des Verbundmaterials zur Erhöhung der Dichte des Verbundmaterials.

10. Verfahren nach Anspruch 7 oder 8, wobei Komponenten, welche in dem oder an dem Brandschutzbauteil angeordnet werden sollen und der Funktion des Brandschutzbauteils dienen, auch als funktionale Komponenten bezeichnet, vor oder nach der Einfüllung des Ausgangsmaterials in die Form und vor dessen Erwärmung zur Wachstumsanregung in der Form positioniert werden.

11. Verfahren nach Anspruch 9, wobei eine funktionale Komponente verwendet wird, welche an einer solchen Oberfläche eine Oberflächenstruktur aufweist, welche von dem Ausgangsmaterial bedeckt wird.

12. Verfahren nach einem der Anspruch 7 bis 10, wobei zumindest die erste Erwärmung des Ausgangsmaterials mittels natürlichen Lichts erfolgt, wobei eine Form verwendet wird, welche transparent ist für zumindest den Wellenlängenbereich des Infrarot- und des sichtbaren Lichts.

## Claims

1. Fire protection device that bounds a space on one or more sides with at least one wall that bounds the space or a hollow body that bounds the space, referred to collectively hereinafter as fire protection component, having at least one fire resistance of the EI; EW 15 class, **characterized in that** the fire protection component consists of a composite material including cellulose fibres as volume-forming constituent, also referred to hereinafter as substrate, and **in that** the volume of the cellulose fibres is permeated by a no longer living filamentous organism of a fungal mycelium.

2. Fire protection device according to Claim 1, **characterized in that** the cellulose fibres present are of one type from the following list or a mixture of two or more types from the list: wood fibres, hemp, flax, cereal straw, maize straw, bamboo, meal, wastes from biogasification, cellulose regenerates, cellulose derivatives.

3. Fire protection device according to either of the preceding claims, **characterized in that** the fungal mycelium is at least one species of lignin-degrading fungus.

4. Fire protection device according to any of the preceding claims, **characterized in that** the material of the fire protection component comprises shredded or ground gypsum, preferably waste gypsum, as an additive.

5. Fire protection device according to any of the preceding claims, **characterized in that** the wall(s) of the fire protection component has/have a single ply and/or the fire protection component is integrated.

6. Fire protection device according to any of the preceding claims, **characterized in that** the fire protection device is a fire protection housing.

7. Method of producing a fire protection device according to any of the preceding claims, comprising the following steps in the sequence specified:
- providing a mixture of cellulose fibres and spores of a fungus,
- producing a pasty starting material from the cellulose fibre-spore mixture by supplying liquid, in such a way that the starting material has a pH in the range from 4 to 6,
- introducing the pasty starting material into a mould,
- heating the starting material to a temperature in the range from 20°C to less than 50°C in order to induce growth of the fungal mycelium,
- heating the composite material that has resulted from the growth of the fungal mycelium to a temperature in the range from 50°C to less than 100°C in order to end the process of growth of the fungal mycelium, and
- removing the solidified fire protection component from the mould.

8. Method according to Claim 7, wherein the temperatures in the first and/or second heating operation are generated in the core region of the wall.

9. Method according to Claim 7 or 8, wherein, in a further method step, a compression of the composite material is effected to increase the density of the composite material.

10. Method according to Claim 7 or 8, wherein components that are to be disposed in or on the fire protection component and serve to fulfil the function of the fire protection component, also referred to as functional components, are positioned in the mould before or after the introduction of the starting material into the mould and before the heating thereof to induce growth.

11. Method according to Claim 9, wherein a functional component having a surface structure, covered by the starting material, on such a surface is used.

12. Method according to any of Claims 7 to 10, wherein at least the first heating operation of the starting material is effected with natural light, using a mould transparent at least to the wavelength range of infrared and visible light.

## Revendications

1. Dispositif de protection contre l'incendie, qui délimite un espace sur un ou plusieurs côtés avec au moins une paroi délimitant l'espace ou un corps creux délimitant l'espace, désigné ci-après globalement comme composant de protection contre l'incendie, qui présentent au moins une résistance au feu de la classe EI ; EW 15, **caractérisé en ce que** le composant de protection contre l'incendie est constitué d'un matériau composite qui présente des fibres de cellulose en tant que constituant formant un volume, désigné ci-après également comme substrat, et **en ce que** le volume des fibres de cellulose est traversé par un organisme filamenteux d'un mycélium fongique qui n'est plus vivant.

2. Dispositif de protection contre l'incendie selon la revendication 1, **caractérisé en ce qu'**il contient en tant que fibres de cellulose une espèce de la liste suivante ou un mélange de plusieurs espèces de la liste : fibres de bois, chanvre, lin, paille de céréales, paille de maïs, bambou, farine, déchets de la biogazéification, produits régénérés de cellulose, dérivés de cellulose.

3. Dispositif de protection contre l'incendie selon l'une quelconque des revendications précédentes, **caractérisé en ce que** le mycélium fongique est au moins une espèce de champignon dégradant la lignine.

4. Dispositif de protection contre l'incendie selon l'une quelconque des revendications précédentes, **caractérisé en ce que** le matériau du composant de protection contre l'incendie comprend du gypse déchiqueté ou broyé, de préférence du gypse de rebut, en tant qu'additif.

5. Dispositif de protection contre l'incendie selon l'une quelconque des revendications précédentes, **caractérisé en ce que** la paroi ou les parois du composant de protection contre l'incendie sont configurées à une seule couche et/ou le composant de protection contre l'incendie est configuré d'une seule pièce.

6. Dispositif de protection contre l'incendie selon l'une quelconque des revendications précédentes, **caractérisé en ce que** le dispositif de protection contre l'incendie est un boîtier de protection contre l'incendie.

7. Procédé de fabrication d'un dispositif de protection contre l'incendie selon l'une quelconque des revendications précédentes, comprenant les étapes de procédé suivantes dans l'ordre indiqué :
- la fourniture d'un mélange de fibres de cellulose et de spores d'un champignon,
- la préparation d'un matériau de départ pâteux à partir du mélange de fibres de cellulose et de spores au moyen d'un apport de liquide, de telle sorte que le matériau de départ présente un pH dans la plage allant de 4 à 6,
- le remplissage du matériau de départ pâteux dans un moule,
- le chauffage du matériau de départ à une température dans la plage allant de 20 °C à moins de 50 °C pour stimuler la croissance du mycélium fongique,
- le chauffage du matériau composite obtenu suite à la croissance du mycélium fongique à une température dans la plage allant de 50 °C à moins de 100 °C pour terminer le processus de croissance du mycélium fongique, et
- le retrait du composant de protection contre l'incendie solidifié du moule.

8. Procédé selon la revendication 7, dans lequel les températures sont générées dans la zone centrale de la paroi lors du premier et/ou du deuxième chauffage.

9. Procédé selon la revendication 7 ou 8, dans lequel, dans une autre étape de procédé, une compression du matériau composite est effectuée pour augmenter la densité du matériau composite.

10. Procédé selon la revendication 7 ou 8, dans lequel des composants destinés à être agencés dans ou sur le composant de protection contre l'incendie et servant à la fonction du composant de protection contre l'incendie, également désignés comme composants fonctionnels, sont positionnés dans le moule avant ou après le remplissage du matériau de départ dans le moule et avant son chauffage pour stimuler la croissance.

11. Procédé selon la revendication 9, dans lequel on utilise un composant fonctionnel qui présente sur une telle surface une structure de surface qui est recouverte par le matériau de départ.

12. Procédé selon l'une quelconque des revendications 7 à 10, dans lequel au moins le premier chauffage du matériau de départ est effectué au moyen de lumière naturelle, un moule qui est transparent au moins pour la plage de longueurs d'onde de la lumière infrarouge et visible étant utilisé.
